# EUROPEAN PATENT APPLICATION

(11) **EP 2 782 157 A2**
(43) Date of publication of application: **24.09.2014**
(21) Application number: 14153956.9
(22) Date of filing: 05.02.2014
(51) Int. Cl.: H01L 51/56, H01L 27/32

(54) **Method for manufacturing display device and display device**

(30) Priority: 22.03.2013 JP 2013061134
(71) Applicant: Kabushiki Kaisha Toshiba, Tokyo 105-8001 (JP)
(72) Inventor: Sakano, Tatsunori, Tokyo, 105-8001 (JP); Miura, Kentaro, Tokyo, 105-8001 (JP); Ueda, Tomomasa, Tokyo, 105-8001 (JP); Saito, Nobuyoshi, Tokyo, 105-8001 (JP); Nakano, Shintaro, Tokyo, 105-8001 (JP); Maeda, Yuya, Tokyo, 105-8001 (JP); Yamaguchi, Hajime, Tokyo, 105-8001 (JP)
(74) Representative: HOFFMANN EITLE

(57) **Abstract**

According to one embodiment, a method for manufacturing a display device (300) is disclosed. The method can include bonding a display body (210) to a filter body (220), irradiating light and separating. The display body (210) includes a first support unit (41) and a display unit (110). The first support unit (41) includes a first substrate (11), a first metal layer (21), and a first resin layer (31). The display unit (110) has a first region (110a) and a second region (110b). The filter body (220) includes a second support unit (42) and a filter unit (120). The second support unit (42) includes a second substrate (12), a second metal layer (22) and a second resin layer (32). The display unit (110) and the filter unit (120) are disposed between the first and second substrates in the bonding. The light is irradiated onto the first and second metal layers (12, 22). The first substrate (11) is separated from the first resin layer (31) and the second substrate (12) is separated from the second resin layer (32).

## Description

### FIELD

Embodiments described herein relate generally to a method for manufacturing the display device and a display device.

### BACKGROUND

In recent years, display devices using display elements such as liquid crystal display elements, electroluminescent (EL) elements, and the like that are formed on a film of transparent plastic, etc., are drawing attention. It is desirable to increase the productivity of such display devices.

### BRIEF DESCRIPTION OF THE DRAWINGS

FIG. 1 A and FIG. 1B are schematic views showing a display device according to a first embodiment;
FIG. 2A to FIG. 2C are schematic plan views showing the display device according to the first embodiment;
FIG. 3A to FIG. 3C are schematic cross-sectional views in order of the processes, showing a method for manufacturing the display device according to the first embodiment; and
FIG. 4A and FIG. 4B are schematic cross-sectional views in order of the processes, showing a method for manufacturing the display device according to the first embodiment.

### DETAILED DESCRIPTION

According to one embodiment, a method for manufacturing a display device is disclosed. The method can include bonding a display body to a filter body, irradiating light and separating. The display body includes a first support unit and a display unit. The first support unit includes a first substrate, a first metal layer, and a first resin layer. The first metal layer is provided on the first substrate. The first metal layer has a first linear coefficient of thermal expansion and a plurality of openings. The first resin layer is provided on the first metal layer. The first substrate is light-transmissive. The first resin layer has a second linear coefficient of thermal expansion different from the first linear coefficient of thermal expansion. The display unit is provided on the first resin layer. The display unit has a first region and a second region. The second region is arranged with the first region when projected onto a plane perpendicular to a stacking direction from the first substrate toward the first resin layer. The second region has a portion overlapping the openings when projected onto the plane. The first region is light-shielding. The second region is light-transmissive. The filter body includes a second support unit and a filter unit. The second support unit includes a second substrate, a second metal layer provided on the second substrate, and a second resin layer provided on the second metal layer. The second metal layer has a third linear coefficient of thermal expansion. The second resin layer has a fourth linear coefficient of thermal expansion different from the third linear coefficient of thermal expansion. The filter unit is provided on the second resin layer. The filter unit includes a colored layer including a color filter. The display unit and the filter unit are disposed between the first substrate and the second substrate in the bonding. In the irradiating the light, the light is irradiated onto the first metal layer through the first substrate and onto the second metal layer through at least a portion of the first substrate, the openings, and the second region. In the separating, the first substrate is separated from the first resin layer and the second substrate is separated from the second resin layer.

According to one embodiment, a display device includes a first resin layer having a plurality of first portions and a second portion provided between the plurality of first portions, a thickness of the second portion being thicker than a thickness of the first portions, a display unit having a plurality of first regions and a second region, the plurality of first regions being provided respectively on the plurality of first portions, the second region being provided on the second portion, the plurality of first regions being light-shielding, the second region being light-transmissive, a filter unit provided on the display unit, the filter unit including a colored layer including a color filter, and a second resin unit provided on the filter unit.

Various embodiments will be described hereinafter with reference to the accompanying drawings.

The drawings are schematic or conceptual; and the relationships between the thicknesses and widths of portions, the proportions of sizes between portions, etc., are not necessarily the same as the actual values thereof. Further, the dimensions and/or the proportions may be illustrated differently between the drawings, even for identical portions.

In the drawings and the specification of the application, components similar to those described in regard to a drawing thereinabove are marked with like reference numerals, and a detailed description is omitted as appropriate.

### First embodiment

A display device according to the embodiment includes a display device that uses a display element such as, for example, a liquid crystal display element, an electroluminescent (EL) element, etc.

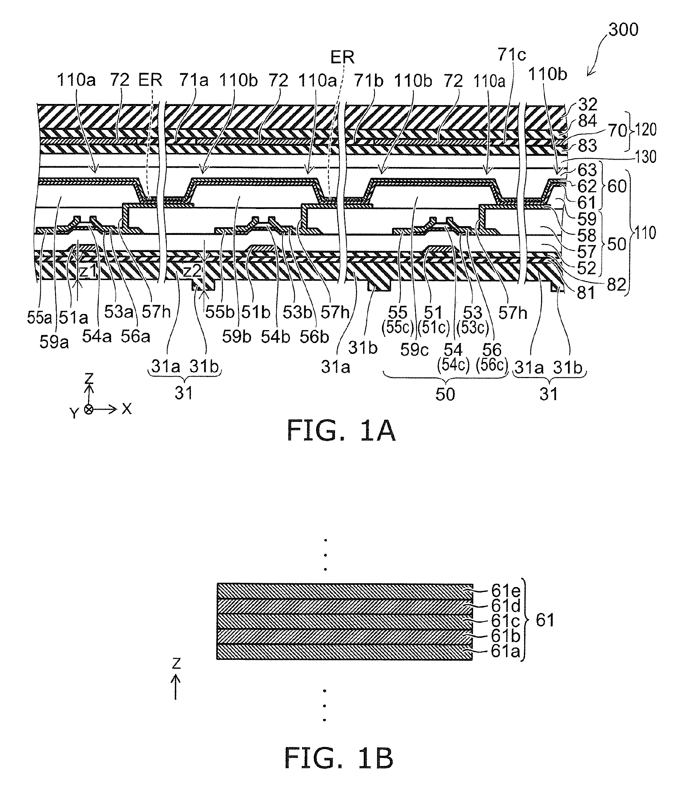

FIG. 1A and FIG. 1B are schematic views showing the display device according to the first embodiment.

FIG. 1A shows the overall of the display device 300. FIG. 1B shows an organic light emitting layer (an organic layer) 61 of the display device 300.

As shown in FIG. 1A, the display device 300 includes a first resin layer 31, a display unit 110, a filter unit 120, and a second resin layer 32. The display unit 110 is provided on the first resin layer 31. The filter unit 120 is provided on the display unit 110. The second resin layer 32 is provided on the filter unit 120.

In the specification of the application, the state of being "provided on" includes not only the state of being provided in direct contact but also the state in which another layer is inserted therebetween.

A direction from the first resin layer 31 toward the second resin layer 32 is taken as a stacking direction (a Z-axis direction). One direction orthogonal to the Z-axis direction is taken as an X-axis direction. A direction orthogonal to the Z-axis direction and the X-axis direction is taken as a Y-axis direction.

First, the first resin layer 31 will be described.

The first resin layer 31 includes multiple first portions 31a and multiple second portions 31b. In the example, the first resin layer 31 has three first portions and three second portions.

The first portions 31a have a first thickness z1. The first thickness z1 is the length of the first portion along the stacking direction (the Z-axis direction). The multiple first portions 31a are arranged with each other when projected onto a plane perpendicular to the stacking direction.

The multiple second portions 31b are disposed between the multiple first portions 31a. The second portions 31b have a second thickness z2. The second thickness z2 is the length of the second portion 31b along the stacking direction (the Z-axis direction). The second thickness z2 is thicker than the first thickness z1.

The first thickness z1 is, for example, not less than 1 µm and not more than 30 µm.

The details of the dispositions of the first portions 31a and the second portions 31b are described below.

The first resin layer 31 may include, for example, a resin having heat resistance. The first resin layer 31 may include, for example, a resin having chemical resistance and dimensional stability. The first resin layer 31 may include, for example, a resin made of a polymer having a structure including an imide group. The first resin layer 31 may include, for example, a polyimide resin. For example, polyamide-imide, polybenzimidazole, polyimide ester, polyetherimide, and polysiloxaneimide may be used as the polyimide resin. The first resin layer 31 may include, for example, at least one selected from an acrylic, an aramid, an epoxy, a cyclic polyolefin, a liquid crystal polymer, a paraxylene resin, a fluoric resin, polyethersulphone (PES), polyethylene naphthalate (PEN), and polyetheretherketone (PEEK).

The first resin layer 31 has, for example, a first water permeability. The first resin layer 31 may or may not be light-transmissive.

The display unit 110 will now be described.

The display unit 110 includes, for example, a first layer 81, a second layer 82, a thin film transistor unit 50, and an organic light emitting unit 60.

The first layer 81 is provided, for example, on each of the multiple first portions 31a of the first resin layer 31 and on each of the multiple second portions 31b of the first resin layer 31.

The water permeability (a second water permeability) of the first layer 81 is, for example, lower than the first water permeability (of the first resin layer 31). The first layer 81 suppresses, for example, the penetration of water into the thin film transistor unit 50. The oxygen permeability of the first layer 81 is, for example, lower than the oxygen permeability of the first resin layer 31. The first layer 81 suppresses, for example, the penetration of oxygen into the thin film transistor unit 50.

The first layer 81 functions as, for example, a barrier layer.

The first layer 81 may include, for example, an inorganic material. For example, at least one selected from a silicon nitride film (SiNₓ), a silicon oxynitride film (SiOₓN_{y}), a silicon oxide film (SiOₓ), and an aluminum oxide film (AlOₓ) may be used as the inorganic material.

The first layer 81 may include, for example, a stacked film of an inorganic film and an organic resin film. Thereby, the stress is relaxed; and the occurrence of cracks is suppressed. The organic resin film may include, for example, a polyimide, an acrylic, a paraxylene resin, etc. In the case where the stacked film is used as the first layer 81, it is favorable for an inorganic material such as a silicon oxide film (SiOₓ), an aluminum oxide film (AlOₓ), etc., to be used as the uppermost layer of the first layer 81.

The thickness of the first layer 81 is, for example, 50 nm to 10 µm. The first layer 81 is, for example, light-transmissive.

The second layer 82 is provided, for example, on the first layer 81. The second layer 82 functions as, for example, a planarizing layer. The second layer 82 may include, for example, a silicon nitride film (SiNₓ), a silicon oxynitride film (SiOₓN_{y}), a silicon oxide film (SiOₓ), or an aluminum oxide film (AlOₓ).

Only one selected from the first layer 81 and the second layer 82 may be provided; or both may be provided. Other layers may be provided in addition to the first layer 81 and the second layer 82.

The thin film transistor unit 50 will now be described.

The thin film transistor unit 50 includes, for example, a gate electrode 51, a gate insulation layer 52, a channel layer 53, an etching stopper layer 54, a source electrode 55, a drain electrode 56, a passivation layer 57, a pixel electrode 58, and a bank 59.

The gate electrode 51 is provided, for example, on the second layer 82 on a portion of each of the multiple first portions 31a. In the example, three gate electrodes 51 (a first gate electrode 51a, a second gate electrode 51b, and a third gate electrode 51c) are provided.

The gate electrodes 51 may include, for example, at least one selected from aluminum (Al), copper (Cu), molybdenum (Mo), tantalum (Ta), titanium (Ti), and tungsten (W) or an alloy including the at least one selected from the group.

The gate insulation layer 52 is provided, for example, on the second layer 82 and on each of the multiple gate electrodes 51. The gate insulation layer 52 covers the gate electrodes 51 (the first gate electrode 51a to the third gate electrode 51c). The gate insulation layer 52 overlaps, for example, each of the multiple first portions 31a and the multiple second portions 31b when projected onto the plane perpendicular to the stacking direction.

The gate insulation layer 52 may include, for example, at least one selected from a silicon nitride film (SiNₓ), a silicon oxynitride film (SiOₓN_{y}), a silicon oxide film (SiOₓ), and an aluminum oxide film (AlOₓ).

The channel layer 53 is provided, for example, on the gate insulation layer 52 on each of the multiple gate electrodes 51. In the example, three channel layers 53 (a first channel layer 53a, a second channel layer 53b, and a third channel layer 53c) are provided.

At least a portion of the first channel layer 53a overlaps the first gate electrode 51a when projected onto the plane perpendicular to the stacking direction. At least a portion of the second channel layer 53b overlaps the second gate electrode 51b when projected onto the plane perpendicular to the stacking direction. At least a portion of the third channel layer 53c overlaps the third gate electrode 51c when projected onto the plane perpendicular to the stacking direction.

The channel layer 53 may include, for example, an oxide semiconductor material. The channel layer 53 may include, for example, InGaZnO or ZnO. The channel layer 53 may include, for example, InSnZnO, InO, or InZnO. The channel layer 53 may include, for example, an organic semiconductor material, polysilicon, or amorphous silicon. The polysilicon may include, for example, a material that has been crystallized by laser annealing, etc. The organic semiconductor material may include, for example, pentacene. In the case where the channel layer 53 includes amorphous silicon, for example, an n⁺ a-Si:H layer may be formed to provide the contact with the source electrode 55 and the drain electrode 56.

The etching stopper layer 54 is provided, for example, on a portion of each of the multiple channel layers 53. In the example, three etching stopper layers 54 (a first etching stopper layer 54a, a second etching stopper layer 54b, and a third etching stopper layer 54c) are provided.

The etching stopper layer 54 may include, for example, at least one selected from a silicon nitride film (SiNₓ), a silicon oxynitride film (SiOₓN_{y}), a silicon oxide film (SiOₓ), and an aluminum oxide film (AlOₓ). To increase the barrier properties, a stacked film including at least two films selected from a silicon nitride film (SiNₓ), a silicon oxynitride film (SiOₓN_{y}), a silicon oxide film (SiOₓ), and an aluminum oxide film (AlOₓ) may be used.

The source electrode 55 is provided, for example, on at least a portion of the multiple etching stopper layers 54, on at least a portion of the multiple channel layers 53, and on a portion of the gate insulation layer 52.

The drain electrode 56 is provided, for example, on a portion of the multiple etching stopper layers 54, on a portion of the multiple channel layers 53, and on a portion of the gate insulation layer 52.

In this example, three source electrodes 55 (a first source electrode 55a, a second source electrode 55b, and a third source electrode 55c) and three drain electrodes 56 (a first drain electrode 56a, a second drain electrode 56b, and a third drain electrode 56c) are provided.

Each of the multiple source electrodes 55 and the multiple drain electrodes 56 may include, for example, at least one selected from titanium (Ti), tantalum (Ta), molybdenum (Mo), tungsten (W), aluminum (Al), copper (Cu), and silver (Ag) or an alloy including the at least one selected from the group.

The same material or different materials may be used for the source electrode 55 and the drain electrode 56.

The passivation layer 57 is provided, for example, on each of the multiple source electrodes 55, on each of the multiple drain electrodes 56, on each of the multiple etching stopper layers 54, and on a portion of the gate insulation layer 52. The passivation layer 57 overlaps, for example, each of the multiple first portions 31a and the multiple second portions 31b of the first resin layer 31 when projected onto the plane perpendicular to the stacking direction.

Multiple contact holes 57h (fourth contact holes) are provided in the passivation layer 57.

The passivation layer 57 (the passivation film) may include, for example, at least one selected from a silicon nitride film (SiNₓ), a silicon oxynitride film (SiOₓN_{y}), a silicon oxide film (SiOₓ), and an aluminum oxide film (AlOₓ).

The pixel electrode 58 is provided, for example, on the passivation layer 57 on a portion of the first portions 31a. In the example, three pixel electrodes 58 (a first pixel electrode 58a, a second pixel electrode 58b, and a third pixel electrode 58c) are provided. A portion of the pixel electrodes 58 overlaps a portion of the drain electrodes 56 when projected onto the plane perpendicular to the stacking direction. The pixel electrodes 58 do not overlap the gate electrodes 51, the channel layers 53, the etching stopper layers 54, and the source electrodes 55 when projected onto the plane perpendicular to the stacking direction. The multiple pixel electrodes 58 are electrically connected respectively to the multiple drain electrodes 56 via the contact holes 57h.

The pixel electrode 58 may include, for example, a material having a high reflectance. The pixel electrode 58 may include, for example, LiF/Al, Al, or Ag.

The bank 59 is provided, for example, on end portions (a first end portion 58p and a second end portion 58q) of the pixel electrode 58 and on a portion of the passivation layer 57. In the example, three banks 59 (a first bank 59a, a second bank 59b, and a third bank 59c) are provided. By providing the banks 59, shorts at the end portions (the first end portion 58p and the second end portion 58q) of the pixel electrodes 58 can be prevented.

The bank 59 may include, for example, a resin such as a polyimide, an acrylic, etc. The bank 59 may include, for example, an inorganic material such as a silicon oxide film (SiOₓ) or a silicon nitride film (SiNₓ).

The organic light emitting unit 60 will now be described.

The organic light emitting unit 60 includes the organic light emitting layer 61, a transparent electrode 62, and a sealing layer 63.

The organic light emitting layer 61 is provided, for example, on each of the multiple banks 59 and on a portion of each of the multiple pixel electrodes 58. The organic light emitting layer 61 also is provided, for example, on a side surface (59s) of each of the multiple banks 59.

As shown in FIG. 1B, the organic light emitting layer 61 includes, for example, a first organic film 61a, a second organic film 61b, a third organic film 61c, a fourth organic film 61d, and a fifth organic film 61e.

The first organic film 61a is provided to cover the multiple banks 59 and a portion of the multiple pixel electrodes 58. The second organic film 61b is provided, for example, on the first organic film 61a. The third organic film 61c is provided, for example, on the second organic film 61b. The fourth organic film 61d is provided, for example, on the third organic film 61c. The fifth organic film 61e is provided, for example, on the fourth organic film 61d.

The first organic film 61a functions as, for example, a hole injection layer. The second organic film 61b functions as, for example, a hole transport layer. The third organic film 61c functions as, for example, a light emitting layer. The fourth organic film 61d functions as, for example, an electron transport layer. The fifth organic film 61e functions as, for example, an electron injection layer. The organic light emitting layer 61 corresponds to, for example, the light emitting layer of an organic electroluminescent element (OLED).

The number of films included in the organic light emitting layer 61 is arbitrary. For example, the hole injection layer (e.g., the first organic film 61a) and the electron injection layer (the fifth organic film 61e) may not be provided in the organic light emitting layer 61.

The first to fifth organic films 61a to 61e may include, for example, an organic material.

The hole injection layer (e.g., the first organic film 61a) may include, for example, 4,4'-bis[N-(1-naphthyl)-N-phenylamino]biphenyl) (α-NPD), (poly(3,4-ethylenedioxythiophene)-poly(styrenesulfonic acid)) Pedot:PPS, (copper phthalocyanine) CuPc, molybdenum trioxide (MoO), etc. In particular, compared to a material formed using vapor deposition, a material that is formable by coating such as Pedot, etc., can cover the unevenness of the foundation layer and can suppress the yield decrease due to shorts, etc.

The hole transport layer (e.g., the second organic film 61b) may include, for example, 4,4'-N,N'-dicarbazolyl biphenyl (CBP), 4,4',4"-tris(N-(3-methyl phenyl)-N-phenylamino)triphenylamine (MTDATA), N,N'-bis(3-methyl phenyl)-(1,1'-biphenyl)-4,4'-diamine (TPD), 4,4'-bis[N-(1-naphthyl)-N-phenylamino]biphenyl (α-NPD), 1,1-bis[4-N,N-di(p-tolyl)amino]phenyl]cyclohexane (TAPC), etc.

For example, the first organic film 61a may have a stacked structure of a layer that functions as a hole injection layer and a layer that functions as a hole transport layer. The first organic film 61a may include a layer other than the layer that functions as the hole injection layer and the layer that functions as the hole transport layer. The first organic film 61a and the second organic film 61b are not limited to these materials.

The organic light emitting layer (e.g., the third organic film 61c) may include, for example, various fluorescent materials such as tris(8-hydroxyquinolinolato)aluminum complex (Alq3), polyphenylene vinylene (PPV), etc. The organic light emitting layer (e.g., the third organic film 61c) may include a mixed material of a host material and a dopant added to the host material. For example, 4,4'-N,N'-bis dicarbazolyl-biphenyl (CBP), 2,9-dimethyl-4,7 diphenyl-1,10-phenanthroline (BCP), triphenyldiamine (TPD), polyvinyl carbazole (PVK), (polyphenylene vinylene) PPT, etc., may be used as the host material. For example, a phosphorescent material such as iridium (III) bis(4,6-di-fluorophenyl)-pyridinate-N,C2']picolinate (Flrpic), tris(2-phenylpyridinato)iridium (III) (Ir(ppy)3), tris[1-phenylisoquinoline-C2,N]iridium (III) (Ir(piq)3), etc., may be used as the dopant material.

For example, the organic light emitting layer (e.g., the third organic film 61c) may have a stacked structure. By using multiple light emitting layers, it is possible to obtain a light emission spectrum having multiple peaks. The organic light emitting layer (e.g., the third organic film 61c) is not limited to these materials.

The electron transport layer (e.g., the fourth organic film 61d) may include, for example, Alq3, (bis(2-methyl-8-quinolinolato) (p-phenylphenolate)aluminum) (BAlq), bathophenanthroline (Bphen), and tris[3-(3-pyridyl)-mesityl]borane (3TPYMB). The electron transport layer (e.g., the fourth organic film 61d) is not limited to these materials.

The electron injection layer (e.g., the fifth organic film 61e) may include, for example, a material including at least one selected from lithium fluoride, cesium fluoride, lithium quinoline complex, etc. The electron injection layer (e.g., the fifth organic film 61e) is not limited to these materials.

The organic light emitting layer 61 is electrically connected to each of the multiple pixel electrodes 58. A portion of the organic light emitting layer 61 overlaps, for example, at least a portion of each of the multiple pixel electrodes 58 when projected onto the plane perpendicular to the stacking direction. The overlapping portions are light emitting regions ER that emit light. A portion of the organic light emitting layer 61 (e.g., the first organic film 61a) contacts, for example, the pixel electrodes 58.

The organic light emitting layer 61 has the light emitting regions ER and a non-light emitting region. The non-light emitting region is a region where the light is not emitted. For example, the non-light emitting region does not overlap the pixel electrodes 58 when projected onto the plane perpendicular to the stacking direction. The non-light emitting region overlaps, for example, the banks 59.

The transparent electrode 62 is provided on the organic light emitting layer 61. The transparent electrode 62 may include, for example, ITO and MgAg. The transparent electrode 62 is electrically connected to the organic light emitting layer 61 and each of the multiple pixel electrodes 58.

The sealing layer 63 is provided on the transparent electrode 62. The sealing layer 63 is, for example, light-transmissive.

The sealing layer 63 may include, for example, at least one selected from a silicon nitride film (SiNₓ), a silicon oxynitride film (SiOₓN_{y}), a silicon oxide film (SiOₓ), and an aluminum oxide film (AlOₓ).

The sealing layer 63 may include, for example, a stacked film of an inorganic film and an organic resin film. Thereby, the stress is relaxed; and the occurrence of cracks is suppressed. The organic resin film may include, for example, a polyimide, an acrylic, a paraxylene resin, etc. In the case where a stacked film is used as the sealing layer 63, it is favorable for an inorganic material such as a silicon oxide film (SiOₓ), an aluminum oxide film (AlOₓ), etc., to be used as the uppermost layer of the sealing layer 63.

The display unit 110 will now be described further.

The display unit 110 has multiple first regions 110a and multiple second regions 110b. The multiple second regions 110b are provided respectively between the multiple first regions 110a.

The first regions 110a are provided, for example, on the first portions 31a of the first resin layer 31. The second regions 110b are provided, for example, on the second portions 31b.

The first regions 110a are, for example, light-shielding. For example, the gate electrodes 51, the source electrodes 55, the drain electrodes 56, and the pixel electrodes 58 are disposed in the first regions 110a. For example, the light emitting regions ER are disposed in the first regions 110a.

The second regions 110b are, for example, light-transmissive. For example, the first resin layer 31, the first layer 81, the second layer 82, the gate insulation layer 52, the passivation layer 57, the banks 59, the organic light emitting layer 61, the transparent electrode 62, and the sealing layer 63 are disposed in the second regions 110b.

Light is emitted from the light emitting regions ER of the organic light emitting layer 61 (e.g., the third organic film 61c) by switching the thin film transistor unit 50 to the on-state and supplying a current to the organic light emitting layer 61 by applying a voltage to the source electrodes 55 (the cathodes) and the transparent electrode 62 (the anode).

For example, the light emitted from the organic light emitting layer 61 is emitted from the display unit 110 by passing through the transparent electrode 62 and the sealing layer 63. The light travels mainly from the first resin layer 31 toward the second resin layer 32. In other words, the intensity of the component of the light emitted from the organic light emitting layer 61 from the first resin layer 31 toward the second resin layer 32 is higher than the intensity of the component from the second resin layer 32 toward the first resin layer 31. In other words, in the example, the upper surface (the front surface of the sealing layer 63) is used as the light emitting surface. For example, white light is emitted from the organic light emitting layer 61. The wavelength of the light emitted from the organic light emitting layer 61 is, for example, 300 nm to 1000 nm.

The filter unit 120 will now be described.

The filter unit 120 includes, for example, a third layer 83, a colored layer 70, and a fourth layer 84.

The third layer 83 is provided, for example, on the sealing layer 63. The third layer 83 is, for example, light-transmissive. The third layer 83 functions as, for example, a barrier layer.

The third layer 83 may include the material described in regard to the first layer 81. The third layer 83 may include the same material as the first layer 81; or a different material may be used.

The thickness of the third layer 83 is, for example, 50 nm to 100 µm.

The colored layer 70 is provided, for example, on the third layer 83. The colored layer 70 includes, for example, multiple color filters 71 (a first color filter 71a, a second color filter 71b, and a third color filter 71c).

Each of the multiple color filters 71 has, for example, a different color. The first color filter 71a is, for example, a red filter. The second color filter 71b is, for example, a green filter. The third color filter 71c is, for example, a blue filter.

Each of the multiple color filters 71 overlaps, for example, a portion of the transparent electrode 62, a portion of the organic light emitting layer 61, and at least a portion of the multiple pixel electrodes 58 when projected onto the plane perpendicular to the stacking direction. In other words, the multiple color filters 71 are provided respectively on the light emitting regions ER.

A portion of the colored layer 70 also functions as a light-shielding layer 72 (a light attenuating layer). For example, characteristic fluctuation (e.g., light leakage, etc.) of the thin film transistor units 50 is suppressed by providing the light-shielding layer 72 in the colored layer 70. Because the light emitted from the organic light emitting unit 60 is white in the example, a filter having a low transmittance to a wavelength of, for example, about 400 nm may be provided in a portion of the colored layer 70. A filter that is light-shielding (that attenuates light, e.g., a black layer) may be provided at positions opposing the thin film transistor units 50. The light-shielding layer 72 is described below.

The fourth layer 84 is provided, for example, on the colored layer 70. The fourth layer 84 is, for example, light-transmissive. The fourth layer 84 functions as, for example, a planarizing layer.

The fourth layer 84 may include, for example, the material described in regard to the second layer 82. The fourth layer 84 may include, for example, the same material as the second layer 82; or a different material may be used. The thickness of the fourth layer 84 is, for example, 50 nm to 1 µm.

Only one selected from the third layer 83 and the fourth layer 84 may be provided; or both may be provided. Other layers may be provided in addition to the third layer 83 and the fourth layer 84.

The second resin layer 32 is provided, for example, on the fourth layer 84. The second resin layer 32 is, for example, light-transmissive. The second resin layer 32 may include, for example, the material described in regard to the first resin layer 31. The second resin layer 32 may include, for example, the same material as the first resin layer 31; or a different material may be used.

The thickness of the second resin layer 32 is, for example, not less than 1 µm and not more than 30 µm. In the case where, for example, the light is emitted to the outside from the second resin layer 32, degradation of optical characteristics such as birefringence, absorption, etc., and a decrease of the dimensional stability due to moisture absorption, etc., can be suppressed by the thickness of the second resin layer 32 being set to be 30 µm or less.

In the example, the display device 300 further includes a bonding layer 130. The bonding layer 130 is provided, for example, between the sealing layer 63 and the third layer 83. The bonding layer 130 bonds, for example, the display unit 110 to the filter unit 120.

The bonding layer 130 is, for example, light-transmissive. The bonding layer 130 may include, for example, a bonding agent that is epoxy-based, urethane-based, acrylic, silicone-based, rubber-based, vinyl acetate-based, or inorganic. The thickness of the bonding layer 130 is, for example, 1 µm to 1 mm.

The light emitted from each of the light emitting regions ER of the display unit 110 is emitted outside the display device 300 through, for example, the sealing layer 63, the bonding layer 130, the third layer 83, the color filters (the first to third color filters 71a to 71c), the fourth layer 84, and the second resin layer 32.

In the display device 300, multiple protruding portions (the second portions 31b) are provided in the first resin layer 31. For example, scratches and damage of the display device 300 itself during transfer, etc., can be reduced by the protruding portions. Therefore, the yield can be increased. The productivity can be increased.

The organic light emitting unit 60 of the display device 300 shown in FIGS. 1A and 1B is taken to be a top-emission type in which the light of the organic light emitting layer 61 is emitted from the transparent electrode 62 side. However, the organic light emitting unit 60 may be a bottom-emission type in which the light of the organic light emitting layer 61 is emitted from the pixel electrode 58 side. In such a case, it is possible to form the electrodes opposing the pixel electrodes 58 of an opaque material such as a metal, etc. For the bottom-emission type, the light travels mainly from the second resin layer 32 toward the first resin layer 31. In other words, the intensity of the component of the light emitted from the organic light emitting layer 61 from the second resin layer 32 toward the first resin layer 31 is higher than the intensity of the component of the light emitted from the organic light emitting layer 61 from the first resin layer 31 toward the second resin layer 32.

Although the thin film transistor units 50 of the display device 300 shown in FIGS. 1A and 1B are taken to be the bottom gate-type, the thin film transistor units 50 may be the top-gate type.

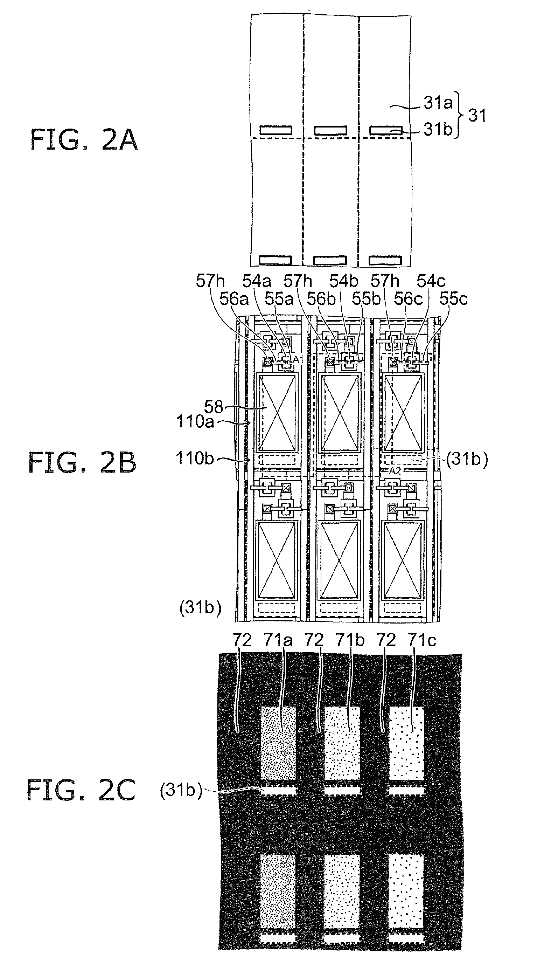

The display device 300 will now be described further with reference to FIG. 2A to FIG. 2C.

FIG. 2A to FIG. 2C are schematic plan views showing the display device according to the first embodiment.

FIG. 2A shows the first resin layer 31. FIG. 2A shows the display unit 110. FIG. 1A is an example of a cross-sectional view along line A1-A2 of FIG. 2B. FIG. 2C shows the filter unit 120.

FIG. 2A to FIG. 2C show an example in which two columns of the pixels of RGB are arranged in parallel. Namely, FIG. 2A to FIG. 2C show an example including six pixels.

The portions other than the etching stopper layers 54, the source electrodes 55, the drain electrodes 56, the contact holes 57h, and the pixel electrodes 58 are not shown in FIG. 2B. The portions other than the first to third color filters 71a to 71c and the light-shielding layer 72 are not shown in FIG. 2C.

As shown in these drawings, the etching stopper layers 54, the source electrodes 55, the drain electrodes 56, the contact holes 57h, and the pixel electrodes 58 which are the main portions of the thin film transistor units 50 are disposed in the first regions 110a but are not disposed in the second regions 110b. Therefore, the damage of the main portions of the thin film transistor units 50 can be reduced even in the case where, for example, a force is applied to the second portions 31b (the protruding portions) of the first resin layer 31 during transfer, etc. The yield can be increased; and the productivity increases.

In the example as shown in FIG. 2B, one second portion 31b is provided for each pixel. One second portion 31b may be provided for three pixels (e.g., RGB).

As shown in FIG. 2C, the light-shielding layer 72 is provided, for example, between the color filters 71. The light-shielding layer 72 is, for example, a black matrix.

An example of a method for manufacturing the display device 300 will now be described.

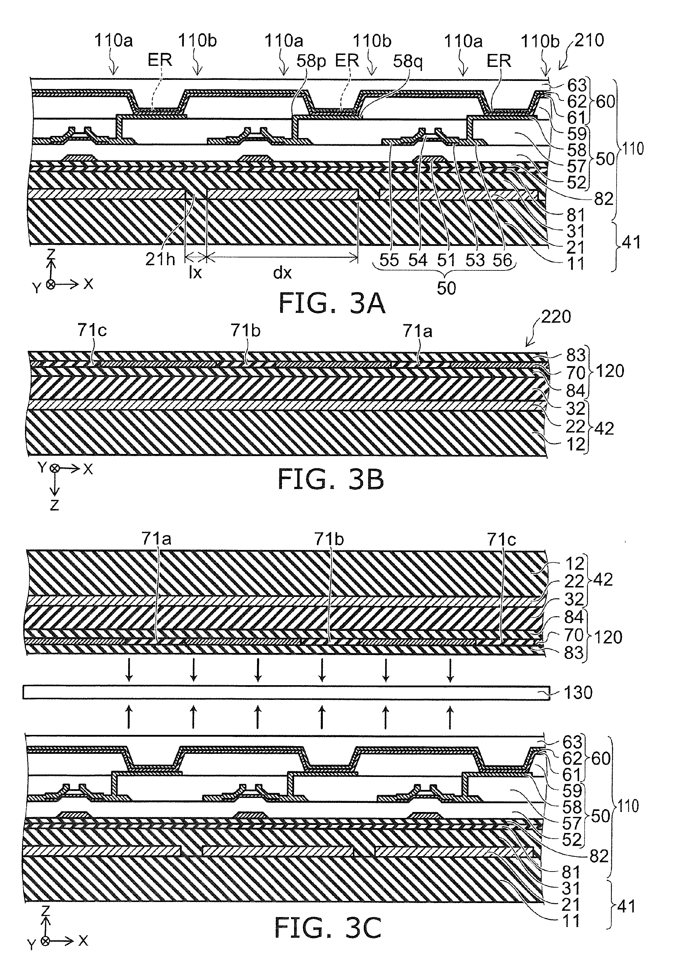

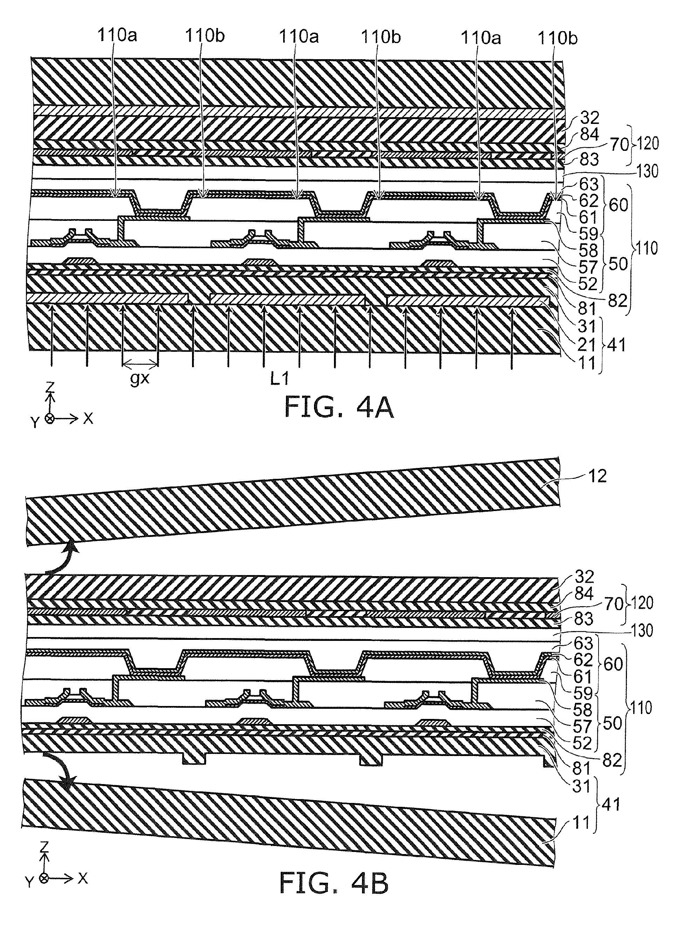

FIG. 3A to FIG. 3C and FIGS. 4A and 4B are schematic cross-sectional views in order of the processes, showing the method for manufacturing the display device according to the first embodiment.

FIG. 3A shows a display body 210 (a first support unit 41 and the display unit 110). FIG. 3B shows a filter body (a second support unit 42 and the filter unit 120). FIG. 3C shows a bonding process between the display body 210 and the filter body 220.

FIG. 4A shows a light irradiation process. FIG. 4B shows a substrate removal process.

First, an example of a method for manufacturing the display body 210 including the first support unit 41 and the display unit 110 will be described with reference to FIG. 3A.

As shown in FIG. 3A, a first metal film that is used to form a first metal layer 21 is formed on a first substrate 11. For example, sputtering is used to form the first metal film.

The first substrate 11 is, for example, light-transmissive. The first substrate 11 may include, for example, glass. The first substrate 11 functions as, for example, a support substrate.

It is favorable for the first metal layer 21 (the first metal film) to include, for example, a material that is highly absorptive of light of a wavelength of 1 µm. The first metal layer 21 may include, for example, at least one selected from a metal, a metal oxide, and a metal nitride. The first metal layer 21 may include, for example, Ti. The first metal layer 21 may include, for example, a metal such as molybdenum (Mo), tantalum (Ta), aluminum (Al), tungsten (W), copper (Cu), etc., or an alloy including one selected from the metals.

The first metal layer 21 has, for example, a first linear coefficient of thermal expansion.

The thickness of the first metal layer 21 (the first metal film) is, for example, 10 nm to 1 µm.

Multiple openings 21h are made in the first metal film. In the example, three openings 21h are made.

The openings 21h are made by, for example, patterning by etching a portion of the first metal film using a resist pattern formed by photolithography, etc., as a mask. The first metal film becomes the first metal layer 21 by making the multiple openings 21h.

For example, the multiple openings 21h are disposed to be separated from each other. A distance dx between the multiple openings 21h is, for example, not more than 100 µm when projected onto the plane perpendicular to the stacking direction. A length lx of each of the multiple openings 21h along the X-axis direction when projected onto the plane perpendicular to the stacking direction is, for example, not less than 0.1 times and not more than 1.2 times the length of each of the multiple pixel electrodes 58 along the X-axis direction when projected onto the plane. Also, the length of each of the multiple openings 21h along the Y-axis direction when projected onto the plane is, for example, not less than 0.1 times and not more than 1.2 times the length of each of the multiple pixel electrodes 58 along the X-axis direction when projected onto the plane. The length lx of each of the multiple openings 21h is, for example, not less than 50 nm and not more than 1 mm.

A first resin film that is used to form the first resin layer 31 is formed on the first metal layer 21. The first resin film is formed by, for example, coating a resin solution. The coating includes, for example, spin coating. Or, printing may be used. The printing may include, for example, screen printing, offset printing, inkjet printing, etc.

The resin solution may include, for example, polyamic acid. Polyamic acid is a precursor of a polyimide resin. The polyamic acid can be obtained by, for example, causing diamine to react with an acid anhydride. The polyimide resin can be obtained by causing the polyamic acid to react in the presence of a solvent.

The first resin layer 31 is formed by, for example, imidizing the first resin film after drying.

The imidization is performed by, for example, heat treatment. By the imidization, for example, dehydration cyclization of the polyamic acid progresses; and a polyimide is formed.

The first resin film also is formed, for example, inside each of the multiple openings 21h. The first resin film formed inside each of the multiple openings 21h is used to form, for example, the second portions 31b.

The first resin layer 31 (the first resin film) is, for example, light-transmissive. The first resin layer 31 (the first resin film) has, for example, a second linear coefficient of thermal expansion. The second linear coefficient of thermal expansion is different from the first linear coefficient of thermal expansion of the first metal layer 21. The first linear coefficient of thermal expansion is, for example, smaller than the second linear coefficient of thermal expansion. The first resin layer 31 (the first resin film) may include, for example, a material having a linear coefficient of thermal expansion that is greatly different from that of the first metal layer 21. The first metal layer 21 may include a material having a linear coefficient of thermal expansion that is greatly different from that of the first resin layer 31.

The thickness of the first resin layer 31 is, for example, not less than 1 µm and not more than 30 µm. For example, the separation from the first substrate 11 described below becomes easier by setting the thickness of the first resin layer 31 to be not less than 1 µm. For example, the decrease of the dimensional stability due to moisture absorption, etc., can be suppressed by setting the thickness of the first resin layer 31 to be 30 µm or less.

The first resin film may be formed to have a thickness greater than 30 µm; and then, after separating from the first substrate 11, the first resin film may be patterned such that the thickness of the first resin layer 31 is not more than 30 µm.

As described above, the first support unit 41 is formed by forming the first metal layer 21 and the first resin layer 31 on the first substrate 11.

In the case where the first resin layer 31 is formed by coating a polyamic acid solution when forming the first support unit 41, there are cases where, for example, the organic solvent of the drying and imidization processes for the polyamic acid solution and moisture that occurs as the imidization progresses may concentrate at the interface between the first metal layer 21 and the first resin film and obstruct the close adhesion between the first metal layer 21 and the first resin film. Therefore, there are cases where, for example, the first resin film (the first resin layer 31) peels from the first metal layer 21, or lifting of the first resin film (the first resin layer 31) unexpectedly occurs in the formation process of the display unit 110.

On the other hand, in the case where the water vapor permeability of the first metal layer 21 is high, for example, moisture does not collect at the interface between the first metal layer 21 and the first resin film; and the adhesion between the first metal layer 21 and the first resin film becomes strong. In such a case, there are cases where discrepancies occur in the subsequent process (described below) of separating the first substrate 11 and the first resin layer 31.

For example, the peeling of the first resin film (the first resin layer 31) from the first metal layer 21 in the formation process of the display unit 110 and the occurrence of defects in the separation process of the first resin layer 31 and the first substrate 11 can be suppressed by appropriately adjusting the type of the first metal layer 21 and the amount of the imidization water that occurs when imidizing the first resin film.

Then, the display unit 110 that includes the thin film transistor units 50 and the organic light emitting unit 60 is formed on the first support unit 41.

First, for example, a first film that is used to form the first layer 81 is formed on the first resin layer 31. For example, plasma CVD (PE-CVD (plasma-enhanced chemical vapor deposition)), sputtering, or atomic layer deposition (ALD) may be used to form the first film.

The first layer 81 is, for example, light-transmissive.

Further, in the example, a second film that is used to form the second layer 82 is formed on the first layer 81. The second layer 82 (the second film) is, for example, light-transmissive. For example, chemical vapor deposition (CVD), sputtering, or atomic layer deposition (ALD) is used to form the second film. The second film may not be formed.

The thin film transistor units 50 are formed on the first layer 81 (the second layer 82).

A first metal thin film that is used to form, for example, the first to third gate electrodes 51a to 51c is formed on the first layer 81. For example, sputtering is used to form the first metal thin film.

The first to third gate electrodes 51a to 51c are formed by, for example, etching a portion of the first metal thin film using a resist pattern formed by photolithography, etc., as a mask. The first metal thin film may be formed after forming a mask beforehand; and the mask may be removed.

The first metal thin film may include, for example, at least one selected from aluminum (Al), copper (Cu), molybdenum (Mo), tantalum (Ta), titanium (Ti), and tungsten (W) or an alloy including the at least one selected from the group. The first metal thin film may be a single-layer film or a stacked film.

The first to third gate electrodes 51a to 51c may be formed of the same material or may be formed of mutually-different materials.

When the gate electrodes 51 are formed, for example, gate interconnects (not shown) that are connected respectively to the gate electrodes 51 also are formed. At this time, multiple first contact holes (not shown) may be made in the first metal thin film. Then, multiple driver ICs (not shown) may be electrically connected respectively to the multiple gate electrodes 51 via the multiple contact holes.

For example, multiple through-holes (not shown) may be made in the first layer 81 and the first resin layer 31 prior to forming the second layer 82 and the first metal thin film on the first layer 81. For example, electrical connections to the gate electrodes 51 (e.g., the first to third gate electrodes 51a to 51c) may be provided respectively via the through-holes after removing a portion (e.g., the first substrate 11 and the first metal layer 21) of the first support unit 41. Thereby, for example, it is possible to mount a drive unit (not shown), etc., to the first resin layer 31 side (the backside) that is exposed by the removal.

For example, a gate insulating film that is used to form the gate insulation layer 52 is formed on the gate electrodes 51 and the first layer 81. For example, chemical vapor deposition (CVD), sputtering, or atomic layer deposition (ALD) is used to form the gate insulating film.

The gate insulation layer 52 is, for example, light-transmissive.

A channel film that is used to form the multiple channel layers 53 (the first channel layer 53a to the third channel layer 53c) is formed on the gate insulation layer 52. For example, chemical vapor deposition (CVD), sputtering, atomic layer deposition (ALD), or the like is used to form the channel film. The multiple channel layers 53 are formed by, for example, patterning the channel film by photolithography, etc. The channel film may be formed after forming a mask beforehand; and the mask may be removed.

An etching stopper film that is used to form, for example, the multiple etching stopper layers 54 (the first to third etching stopper layers 54a to 54c) is formed on the channel layers 53 and the gate insulation layer 52. For example, chemical vapor deposition (CVD), sputtering, or atomic layer deposition (ALD) is used to form the etching stopper film. The multiple etching stopper layers 54 are formed by patterning the etching stopper film by, for example, photolithography, etc. The etching stopper film may be formed after forming a mask beforehand; and the mask may be removed.

For example, second contact holes (not shown) are made in the etching stopper film. Simultaneously, for example, third contact holes (not shown) to the gate interconnects may be made in the etching stopper film. The etching stopper film may be formed by patterning by a self-aligning method using back exposure. Thereby, the patterning precision increases; and, for example, a fine thin film transistor can be obtained.

Back-channel cut thin film transistors, in which the etching stopper layers 54 are not used, may be used. In the case where the channel layers 53 include an oxide semiconductor material, the characteristics of the back channel interface greatly affect the TFT characteristics. Therefore, it is desirable to use the etching stopper layers 54 in such a case.

Then, for example, a second metal thin film that is used to form the multiple source electrodes 55 and the multiple drain electrodes 56 is formed on the etching stopper layers 54 and inside the second contact holes. For example, sputtering is used to form the second metal thin film. The multiple source electrodes 55 (the first to third source electrodes 55a to 55c) and the multiple drain electrodes 56 (the first to third drain electrodes 56a to 56c) are formed by patterning the second metal thin film by photolithography, etc. The second metal thin film may be formed after forming a mask beforehand; and the mask may be removed.

For example, the source electrodes 55 and the drain electrodes 56 are formed simultaneously. At this time, source contacts (not shown) and drain contacts (not shown) may be formed simultaneously.

The source electrodes 55, the drain electrodes 56, the source contacts, and the drain contacts may be formed separately. The source contacts and the drain contacts may not be formed.

The second metal thin film may include, for example, at least one selected from titanium (Ti), tantalum (Ta), molybdenum (Mo), tungsten (W), aluminum (Al), copper (Cu), and silver (Ag) or an alloy including the at least one selected from the group. The second metal thin film may be a single-layer film or a stacked film.

Then, a passivation film that is used to form the passivation layer 57 is formed on a portion of the gate insulation layer 52, on a portion of the etching stopper layers 54, on the source electrodes 55, and on the drain electrodes 56. For example, chemical vapor deposition (CVD), sputtering, or atomic layer deposition (ALD) is used to form the passivation film.

The passivation layer 57 is, for example, light-transmissive.

For example, the multiple fourth contact holes 57h are made by removing a portion of the passivation layer 57. Thereby, a portion of each of the multiple drain electrodes 56 is exposed. Then, a third metal thin film is formed on the passivation layer 57 and inside the fourth contact holes 57h. For example, sputtering is used to form the third metal thin film. The multiple pixel electrodes 58 are formed by patterning the third metal thin film by, for example, photolithography, etc. The pixel electrodes 58 are electrically connected to, for example, the drain electrodes 56. The third metal thin film may be formed after forming a mask beforehand; and the mask may be removed.

The banks 59 are formed on a portion of the passivation layer 57 and on the end portions (the first end portion 58p and the second end portion 58q) of the pixel electrode 58.

For example, coating is used to form the banks 59.

Thereby, the thin film transistor units 50 are formed. Although an example of the thin film transistor units 50 having bottom-gate structures are described above, the thin film transistor units 50 may have other structures (e.g., a top-gate structure, etc.).

In the case where the length x1 of the pixel electrode 58 along the X-axis direction is long (e.g., longer than 100 µm), it is favorable to provide a hole (not shown) in a portion of the pixel electrode 58. The hole functions as, for example, a through-hole through which a first light L1 which is described below passes. Multiple holes may be provided in one pixel electrode 58 (e.g., the first pixel electrode 58a).

Such a hole overlaps, for example, at least one of the openings 21h provided in the first metal layer 21 when projected onto the plane perpendicular to the stacking direction. Thereby, even in the case where the length x1 of the pixel electrode 58 along the X-axis direction is long (e.g., longer than 100 µm), the distance dx between the multiple openings 21h can be 100 µm or less. The separation between the resin layers and the substrates that is described below is easier.

Then, the organic light emitting unit 60 is formed on the thin film transistor units 50.

The organic light emitting layer 61 is formed on a portion of the pixel electrodes 58 and on the banks 59. For example, vacuum vapor deposition is used to form the organic light emitting layer 61.

For example, the first organic film 61a is formed on a portion of the pixel electrodes 58 and on the banks 59. For example, the second organic film 61b is formed on the first organic film 61a. For example, the third organic film 61c is formed on the second organic film 61b. For example, the fourth organic film 61d is formed on the third organic film 61c. For example, the fifth organic film 61e is formed on the fourth organic film 61d.

The transparent electrode 62 is formed on the organic light emitting layer 61 (e.g., the fifth organic film 61e). For example, vacuum vapor deposition is used to form the transparent electrode 62.

For example, the sealing layer 63 is formed on the transparent electrode 62. For example, PE-CVD, chemical vapor deposition (CVD), sputtering, or atomic layer deposition (ALD) is used to form the sealing layer 63.

Thereby, the organic light emitting unit 60 is formed.

Thereby, the display body 210 that includes the first support unit 41 and the display unit 110 is formed.

In the display unit 110, at least a portion of the second regions 110b overlaps at least one of the multiple openings 21h of the first metal layer 21 when projected onto the plane perpendicular to the stacking direction.

A display including the array of an active-matrix display may be formed on the first resin layer 31 using existing technology.

A method for forming the filter body 220 including the second support unit 42 and the filter unit 120 will now be described with reference to FIG. 3B.

As shown in FIG. 3B, a second metal film that is used to form a second metal layer 22 is formed on a second substrate 12. For example, sputtering is used to form the second metal film.

The second substrate 12 is, for example, light-transmissive. The second substrate 12 may include, for example, glass. The second substrate 12 functions as, for example, a support substrate.

The second metal layer 22 (the second metal film) may include, for example, the material described in regard to the first metal layer 21. The second metal layer 22 may include the same material as the first metal layer 21; or a different material may be used.

The second metal layer 22 has, for example, a third linear coefficient of thermal expansion.

The thickness (the length along the stacking direction) of the second metal layer 22 (the second metal film) is, for example, the same as or less than the thickness (the length along the stacking direction) of the first metal layer 21 (the first metal film). The thickness of the second metal layer 22 is, for example, 10 nm to 1 µm.

A second resin film that is used to form the second resin layer 32 is formed on the second metal layer 22. The method described in regard to the formation of the first resin film (the first resin layer 31) may be used to form the second resin film (the second resin layer 32).

The second resin layer 32 (the second resin film) is, for example, light-transmissive. The second resin layer 32 (the second resin film) has, for example, a fourth linear coefficient of thermal expansion. The fourth linear coefficient of thermal expansion is different from the third linear coefficient of thermal expansion of the second metal layer 22. The third linear coefficient of thermal expansion is, for example, smaller than the fourth linear coefficient of thermal expansion. The second resin layer 32 (the second resin film) may include, for example, a material having a linear coefficient of thermal expansion that is greatly different from that of the second metal layer 22. The second metal layer 22 may include a material having a linear coefficient of thermal expansion that is greatly different from that of the second resin layer 32.

Thus, the second metal layer 22 and the second resin layer 32 are formed on the second substrate 12 to form the second support unit 42.

Then, the filter unit 120 is formed on the second support unit 42.

First, a third film that is used to form the fourth layer 84 is formed on the second resin layer 32. For example, the method described in regard to the formation of the second layer 82 may be used to form the fourth layer 84.

The colored layer 70 that includes the multiple color filters 71 (the first to third color filters 71a to 71c) is formed on the third layer 83.

For example, a color resist is used to form the color filters 71. For example, the color filters (the first to third color filters 71a to 71c) are formed for R (red), G (green), and B (blue), respectively. The baking temperature is, for example, 180 °C to 200 °C.

A reflective layer (not shown) may be formed on the color filters 71.

A fourth film that is used to form the third layer 83 is formed on the color filters 71. The method described in regard to the formation of the first layer 81 may be used to form the third layer 83.

Thereby, the filter body 220 that includes the second support unit 42 and the filter unit 120 is formed.

The method for bonding the display body 210 and the filter body 220 will now be described with reference to FIG. 3C.

As shown in FIG. 3C, the display body 210 (the sealing layer 63) and the filter body 220 (the third layer 83) are bonded with the bonding layer 130 interposed. At this time, the display unit 110 and the filter unit 120 are disposed between the first substrate 11 and the second substrate 12.

At this time, the display unit 110 and the filter unit 120 are bonded such that at least portions of the color filters (the first to third color filters 71a to 71c) respectively oppose at least portions of the light emitting regions ER (the pixel electrodes 58).

The method for manufacturing the display device 300 will now be described further with reference to FIG. 4A to FIG. 4C.

As shown in FIG. 4A, the first light L1 is irradiated through the first substrate 11 onto the first metal layer 21. At this time, the first light L1 passing through the first substrate 11 passes through, for example, at least a portion of the multiple openings 21h provided in the first metal layer 21 and the second regions 110b of the display unit 110 and is irradiated onto the second metal layer 22.

When the first light L1 is irradiated, the first metal layer 21 and the second metal layer 22 are heated. Stress occurs between the first metal layer 21 and the first resin layer 31 due to the coefficient of thermal expansion difference between the first metal layer 21 and the first resin layer 31. Also, stress occurs between the second metal layer 22 and the second resin layer 32 due to the coefficient of thermal expansion difference between the second metal layer 22 and the second resin layer 32.

As shown in FIG. 4B, for example, the first substrate 11 and the first resin layer 31 are separated by the stress. Also, the second substrate 12 and the second resin layer 32 are separated. The display device 300 is formed by removing the first substrate 11 and the second substrate 12 that are separated.

For example, the first metal layer 21 remains on the first substrate 11. There are cases where, for example, a portion of the first metal layer 21 is vaporized by the heating. For example, the second metal layer 22 remains on the second substrate 12. There are cases where, for example, a portion of the second metal layer 22 is vaporized by the heating.

The first light L1 is absorbed, for example, at the interface between the first substrate 11 and the first metal layer 21. The first light L1 that is absorbed is converted into heat and is thermally conducted through the first metal layer 21. The interface between the first metal layer 21 and the first resin layer 31 is heated by this heat.

On the other hand, thermal conduction is unnecessary at the second metal layer 22 because the location of the heat conversion is the interface between the second metal layer 22 and the second resin layer 32. The film thickness of the second metal layer 22 may be set to be thinner than that of the first metal layer 21 by considering the throughput of the process.

The first light L1 may include, for example, light centered around a wavelength that is absorbed by the metal layers. It is favorable for the first light L1 to include, for example, light having a high ability to travel in a straight line. The first light L1 may include, for example, laser light. It is favorable for the light source of the first light L1 to include, for example, a laser that can stably produce a high output. For example, a beam having a line configuration may be irradiated by a solid-state laser such as a YAG laser, etc. A XeCl excimer laser may be used. A fiber laser having a wavelength in the infrared region may be used.

In the case where an infrared laser is used as the first light L1, a beam having a line configuration may be irradiated intermittently at a prescribed irradiation spacing gx. The irradiation spacing gx is, for example, not more than 100 µm. By setting the irradiation spacing gx to be 100 µm or less, the separation between the substrates and the resin layers is possible also in regions that are not directly irradiated with the laser. Continuous irradiation may be combined with intermittent irradiation.

For example, a lamp may be used for the first light L1. The first light L1 may include microwaves.

The first light L1 enters from the openings 21h of the first metal layer 21 and passes through the second regions 110b of the display unit 110. Because the second regions 110b are light-transmissive, the first light L1 can reach the second metal layer 22. The main portions of the thin film transistor units 50 included in the light emitting regions ER (e.g., the gate electrodes 51, the channel layers 53, the source electrodes 55, the drain electrodes 56, and the pixel electrodes 58) are not disposed in the second regions 110b. Therefore, the performance of the thin film transistor units 50 does not degrade due to the irradiation of the first light L1.

By providing the multiple openings 21h in the first metal layer 21, the process of irradiating the first light L1 onto the first metal layer 21 can also irradiate the first light L1 onto the second metal layer 22. Therefore, for example, the first metal layer 21 and the second metal layer 22 can be heated simultaneously; and the number of processes can be reduced. The productivity of the display device 300 can be increased.

The method for manufacturing the display device will now be described further.

A glass substrate (the first substrate 11) having a thickness of 700 µm is cleaned, for example, for 45 seconds using dilute hydrofluoric acid (DHF). The dilute hydrofluoric acid may be, for example, a mixture of 1 part hydrofluoric acid and 100 parts purified water. After the dilute hydrofluoric acid cleaning, rinsing with water is performed, for example, for not less than 5 minutes.

A titanium (Ti) layer (the first metal layer 21) is formed by sputtering with a thickness of 200 nm on the glass substrate that was rinsed with water. The multiple openings 21h are made by patterning the titanium layer.

A polyimide layer (the first resin layer 31) is formed with a thickness of 10 µm (micrometers) on the patterned titanium layer by spin coating. After the spin coating, pre-baking is performed, for example, consecutively for 90 seconds at 70 °C and then for 240 seconds at 140 °C. The pre-baking is performed, for example, using a hotplate. After the pre-baking, the main baking is performed, for example, for 30 minutes at 350 °C. The main baking is performed, for example, in a clean oven.

Thereby, the first support unit 41 is formed. The second support unit 42 (the second substrate 12, the second metal layer 22, and the second resin layer 32) is formed by a similar method except for the thickness of the titanium layer (the second metal layer 22) being thinner. The thickness of the titanium layer (the second metal layer 22) is, for example, 100 nm.

A SiO₂ layer (the first layer 81) is formed on the polyimide layer by, for example, PE-CVD. The thickness of the SiO₂ layer is, for example, 130 nm.

The gate electrodes 51 of an Al film and a Mo film are formed on the SiO₂ layer. A SiO₂ layer (the gate insulation layer 52) is formed with a thickness of 300 nm on the gate electrodes 51. An IGZO layer (the channel layers 53) is formed with a thickness of 30 nm on the SiO₂ layer. A SiO₂ layer (the etching stopper layers 54) is formed with a thickness of 30 nm on the IGZO layer.

After forming the source electrodes 55 and the drain electrodes 56, a SiO₂ layer (the passivation layer 57) is formed with a thickness of 90 nm. A LiF/Al electrode (the pixel electrodes 58) is formed with a thickness of 100 to 150 nm on the SiO₂ layer.

Then, as the organic light emitting layer 61, the second organic film 61b (e.g., a hole transport layer) is formed with a thickness of 150 nm by vapor deposition. The third organic film 61c (e.g., a light emitting layer) is formed with a thickness of 26 nm on the second organic film 61b by vapor deposition. Further, the fourth organic film 61d (e.g., an electron transport layer) is formed with a thickness of 20 nm by vapor deposition.

ITO (the transparent electrode 62) is formed with a thickness of 60 nm on the organic light emitting layer 61. Then, a SiN_{x/}SiOₓ layer (the sealing layer 63) is formed by PE-CVD. Or, a SiOₓ/paraxylene layer (the sealing layer 63) is formed by sputtering.

Thereby, the display unit 110 (the display body 210) is formed.

A SiN_{x/}SiOₓ layer (the fourth layer 84) is formed by, for example, PE-CVD on the polyimide layer (the second resin layer 32) of the second support unit 42 that is formed by the method described above. The thickness of the SiNₓ layer is, for example, 200 nm; and the thickness of the SiOₓ layer is, for example, 130 nm.

The colors of RGB are formed on the SiN_{x/}SiOₓ layer by, for example, forming the color filters (the first to third color filters 71a to 71c) using a color resist at a baking temperature of 180 to 200 °C.

Thereby, the filter unit 120 (the filter body 220) is formed.

The SiN_{x/}SiOₓ layer or the SiOₓ/paraxylene layer (the sealing layer 63) of the display unit 110 is bonded to the color filters using a bonding agent (the bonding layer 130).

For example, a laser having a peak wavelength in the wavelength range of 10 nm to 20000 nm (nanometers) is irradiated onto the glass substrate (the first substrate 11). At this time, the energy density range is, for example, 1 µJ/cm² to 1000 J/cm². The scanning pitch (the irradiation spacing gx) is set to be, for example, not more than 100 µm. Thereby, the separation between the glass substrates and the resin layers is easier. Then, both glass substrates (the first substrate 11 and the second substrate 12) are removed.

Thereby, the display device 300 is formed. The productivity of the method for manufacturing the display device is high.

According to the manufacturing method according to the embodiment, a display device and a method for manufacturing the display device having high productivity can be provided.

In the specification of the application, "perpendicular" and "parallel" refer to not only strictly perpendicular and strictly parallel but also include, for example, the fluctuation due to manufacturing processes, etc. It is sufficient to be substantially perpendicular and substantially parallel.

Hereinabove, embodiments of the invention are described with reference to specific examples. However, the embodiments of the invention are not limited to these specific examples. For example, one skilled in the art may similarly practice the invention by appropriately selecting specific configurations of components included in the display device and the method for manufacturing the display device such as the substrate, the metal layer, the resin layer, the thin film transistor unit, the organic light emitting unit, the filter unit, the bonding layer, etc., from known art; and such practice is within the scope of the invention to the extent that similar effects are obtained.

Further, any two or more components of the specific examples may be combined within the extent of technical feasibility and are included in the scope of the invention to the extent that the purport of the invention is included.

Moreover, all methods for manufacturing display devices and display devices practicable by an appropriate design modification by one skilled in the art based on the methods for manufacturing display devices and the display devices described above as embodiments of the invention also are within the scope of the invention to the extent that the spirit of the invention is included.

Various other variations and modifications can be conceived by those skilled in the art within the spirit of the invention, and it is understood that such variations and modifications are also encompassed within the scope of the invention.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

## Claims

1. A method for manufacturing a display device (300), comprising:
bonding a display body (210) to a filter body (220),
the display body (210) including
a first support unit (41) including a first substrate (11), a first metal layer (21), and a first resin layer (31), the first metal layer (21) being provided on the first substrate (11), the first metal layer (21) having a first linear coefficient of thermal expansion and a plurality of openings (21h), the first resin layer (31) being provided on the first metal layer (21), the first substrate (11) being light-transmissive, the first resin layer (31) having a second linear coefficient of thermal expansion different from the first linear coefficient of thermal expansion, and
a display unit (110) provided on the first resin layer (31), the display unit (110) having a first region (110a) and a second region (110b), the second region (110b) being arranged with the first region (110a) when projected onto a plane perpendicular to a stacking direction from the first substrate (11) toward the first resin layer (31), the second region (110b) having a portion overlapping the openings (21h) when projected onto the plane, the first region (110a) being light-shielding, the second region (110b) being light-transmissive,
the filter body (220) including
a second support unit (42) including a second substrate (12), a second metal layer (22) provided on the second substrate (12), and a second resin layer (32) provided on the second metal layer (22), the second metal layer (22) having a third linear coefficient of thermal expansion, the second resin layer (32) having a fourth linear coefficient of thermal expansion different from the third linear coefficient of thermal expansion, and
a filter unit (120) provided on the second resin layer (32), the filter unit (120) including a colored layer (70) including a color filter (71),
the display unit (110) and the filter unit (120) being disposed between the first substrate and the second substrate in the bonding;
irradiating light onto the first metal layer (21) through the first substrate (11) and irradiating the light onto the second metal layer (22) through at least a portion of the first substrate (11), the openings (21h), and the second region (110b); and
separating the first substrate (11) from the first resin layer (31) and separating the second substrate (21) from the second resin layer (32).

2. The method according to claim 1, wherein
the display unit (110) includes:
a thin film transistor unit (50) including a pixel electrode (58); and
an organic layer (61) provided on the thin film transistor unit (50) to be electrically connected to the pixel electrode (58), the organic layer (61) having a light emitting region (ER) overlapping the pixel electrode (58) when projected onto the plane, and
the first region (110a) includes the thin film transistor unit (50) and the light emitting region (ER).

3. The method according to claim 2, wherein
the organic layer (61) further has a non-light emitting region not overlapping the pixel electrode (58) when projected onto the plane, the non-light emitting region being arranged with the light emitting region (ER) when projected onto the plane, and
the second region (110b) includes at least a portion of the non-light emitting region.

4. The method according to claim 2, wherein
a length of each of the plurality of openings (21h) along a direction perpendicular to the stacking direction is not less than 0.1 times and not more than 1.2 times of a length of the pixel electrode (58) along the perpendicular direction.

5. The method according to one of claims 1-4, wherein a length of each of the plurality of openings (21h) when projected onto the plane is not less than 50 nm and not more than 1 mm.

6. The method according to one of claims 1-5, wherein a distance between the plurality of openings (21h) when projected onto the plane is not more than 100 µm.

7. The method according to one of claims 1-6, wherein a length of the second metal layer (22) along the stacking direction is shorter than a length of the first metal layer (21) along the stacking direction.

8. The method according to one of claims 1-7, wherein the light is emitted from a laser.

9. The method according to claim 1, wherein the first resin layer (31) and the second resin layer (32) include a polyimide.

10. The method according to one of claims 1-9, wherein the first metal layer (21) and the second metal layer (22) include at least one selected from a metal, a metal oxide, and a metal nitride.

11. The method according to one of claims 1-10, wherein
a thickness of the first metal layer (21) is not less than 10 nanometers and 1 micrometers,
a thickness of the second metal layer (22) is not less than 10 nanometers and 1 micrometers.

12. The method according to one of claims 1-11, wherein at least one of the first metal layer (21) and the second metal layer (22) includes at least one of a film of a metal of at least one selected from Ti (titanium), molybdenum (Mo), tantalum (Ta), aluminum (Al), tungsten (W) and copper (Cu), and an alloy film including the metal.

13. The method according to one of claims 1-12, wherein at least one of the first resin layer (31) and the second resin layer (32) includes at least one selected from an acrylic, an aramid, an epoxy, a cyclic polyolefin, a liquid crystal polymer, a paraxylene resin, a fluoric resin, polyethersulphone, polyethylene naphthalate, and polyetheretherketone.

14. The method according to one of claims 1-13, wherein a thickness of the first resin layer (31) and a thickness of the second resin layer (32) are not less than 1 micrometers and not more than 30 micrometers.

15. The method according to one of claims 1-14, wherein the bonding includes bonding the display unit (110) to the filter unit (120) via a bonding layer (130).

16. The method according to claim 11, wherein the bonding layer (130) includes at least one selected from an epoxy-based bonding agent, a urethane-based bonding agent, an acrylic bonding agent, a silicone-based bonding agent, a rubber-based bonding agent, a vinyl acetate-based bonding agent, or an inorganic bonding agent.

17. The method according to one of claims 1-16, wherein at least one of the first substrate (11) and the second substrate (12) is a glass substrate.

18. The method according to one of claims 1-17, wherein the irradiating the light includes heating the first metal layer (21) and causing a stress to occur between the first metal layer (21) and the first resin layer (31).

19. The method according to one of claims 1-18, wherein the irradiating the light includes heating the second metal layer (22) and causing a stress to occur between the second metal layer (22) and the second resin layer (32).

20. A display device (300), comprising:
a first resin layer (31) having a plurality of first portions (31a) and a second portion (31b) provided between the plurality of first portions (31a), a thickness of the second portion (31b) being thicker than a thickness of the first portions (31a);
a display unit (110) having a plurality of first regions (110a) and a second region (110b), the plurality of first regions (110a) being provided respectively on the plurality of first portions (31a), the second region (110b) being provided on the second portion (31b), the plurality of first regions (110a) being light-shielding, the second region (110b) being light-transmissive;
a filter unit (120) provided on the display unit (110), the filter unit (120) including a colored layer (70) including a color filter (7a); and
a second resin unit (32) provided on the filter unit (120).
